# EUROPEAN PATENT SPECIFICATION

(11) **EP 4 379 320 B1**
(45) Date of publication and mention of the grant of the patent: **31.12.2025**
(21) Application number: 23211935.4
(22) Date of filing: 24.11.2023
(51) Int. Cl.: G01C 19/5719, G01C 19/5733

(54) **MICROELECTROMECHANICAL DEVICE WITH TEST STRUCTURE, TEST EQUIPMENT FOR TESTING MICROELECTROMECHANICAL DEVICES AND METHOD FOR MANUFACTURING A MICROELECTROMECHANICAL DEVICE**
MIKROELEKTROMECHANISCHE VORRICHTUNG MIT TESTSTRUKTUR, TESTAUSRÜSTUNG ZUM TESTEN VON MIKROELEKTROMECHANISCHEN VORRICHTUNGEN UND VERFAHREN ZUR HERSTELLUNG EINER MIKROELEKTROMECHANISCHEN VORRICHTUNG
DISPOSITIF MICROÉLECTROMÉCANIQUE AVEC STRUCTURE DE TEST, ÉQUIPEMENT DE TEST POUR TESTER DES DISPOSITIFS MICROÉLECTROMÉCANIQUES ET PROCÉDÉ DE FABRICATION D'UN DISPOSITIF MICROÉLECTROMÉCANIQUE

(30) Priority: 30.11.2022 IT 202200024732
(43) Date of publication of application: 05.06.2024
(73) Proprietor: STMicroelectronics S.r.l., 20864 Agrate Brianza (MB) (IT)
(72) Inventor: GUERINONI, Luca, 24022 ALZANO LOMBARDO (BG) (IT); FEDELI, Patrick, 20030 SENAGO (MI) (IT); FALORNI, Luca Giuseppe, 20812 LIMBIATE (MB) (IT)
(74) Representative: Studio Torta S.p.A.

(56) References cited:
- EP-B1- 2 647 954
- US-A1- 2013 233 048
- US-A1- 2016 169 933

## Description

### TECHNICAL FIELD

The present invention relates to a microelectromechanical device with a test structure, a test equipment for testing microelectromechanical devices and a method for manufacturing a microelectromechanical device.

### BACKGROUND

As is known, microelectromechanical devices with complex structures, such as inertial sensors and in particular gyroscopes, may be subject to unwanted vibration modes triggered in the presence of stresses at certain frequencies.

For example, uniaxial, biaxial or triaxial microelectromechanical gyroscopes may comprise one or more drive masses and one or more detection masses, elastically constrained to a substrate and to each other, so as to have predetermined relative degrees of freedom. In use, the drive masses are set to oscillation with controlled drive frequency and amplitude and drag the detection masses, which in turn vibrate according to the degrees of freedom allowed by the constraints if the gyroscope rotates around corresponding rotation axes. In some cases, a single mass may be constrained to the substrate with multiple degrees of freedom and is used as both drive mass and detection mass. The vibration modes that generate the useful signal are also said operational vibration modes and the operation of the gyroscopes is based thereon.

However, the higher harmonics of the drive frequency may fall in the vicinity of natural frequencies of spurious vibration modes, which may thus be triggered and, in some circumstances, distort the response of the device. In gyroscopes, spurious resonance modes may be due both to nonlinearities of the structure and to forcing, typically of square-wave type.

The effects of spurious vibration modes may be partially mitigated with some measures. For example, the microstructure (drive masses, detection masses and constraints) may be designed with a twofold perspective: on the one hand, making sure that the resonance frequencies associated with the spurious vibration modes are far enough from the harmonics of the drive frequency to avoid the triggering of unwanted phenomena during operation; and on the other hand, reducing the mechanical nonlinearities of the microstructure. Furthermore, the square-wave forcing may then be replaced by a sinusoidal forcing, which generates lower contributions in terms of higher harmonics.

Despite the precautions, however, the intrinsic process variabilities inevitably cause a certain percentage of rejects out of the total, both because the microstructure is so complex that it is practically impossible to control all possible spurious vibration modes, and because limiting the mechanical nonlinearities, which is already difficult per se, may often clash with the increasingly frequent request of reducing the dimensions of the same devices. Even sinusoidal forcing is often impractical, because it is excessively expensive in terms of energy consumption and architectural complexity.

The problem of rejects due to the presence of spurious vibration modes, in addition to not being able to be eliminated, is critical because the tests on the devices may only be performed at the end of the assembly on the finished product. As a result, not only do defective devices have to be eliminated, but the time, machines and materials required for assembly and packaging are also wasted.

US 2016/169933 A1 discloses a microelectromechanical device comprising a support body and a movable mass of semiconductor material, elastically constrained to the support body so as to be able to oscillate along one or more axes. Fixed detection electrodes are rigidly connected to the support body and capacitively coupled to the at least one movable mass.

### SUMMARY

The aim of the present invention is to provide a test equipment for testing microelectromechanical devices and a method for manufacturing a microelectromechanical device which allow the limitations described to be overcome or at least mitigated.

According to the present invention there are provided a microelectromechanical device with a test structure, a test equipment for testing microelectromechanical devices and a method for manufacturing a microelectromechanical device as defined in claims 1, 14 and 15, respectively.

### BRIEF DESCRIPTION OF THE FIGURES

For a better understanding of the invention, some embodiments thereof will now be described, purely by way of non-limiting example and with reference to the attached drawings, wherein:
- Figure 1 is a simplified schematic view of a semiconductor wafer and a test machine forming a test equipment in accordance with an embodiment of the present invention;
- Figure 2 is a top-plan view of a microelectromechanical device in accordance with an embodiment of the present invention, integrated in the wafer of Figure 1;
- Figure 3 is a cross-section of the microelectromechanical device of Figure 2, taken along line III-III of Figure 2;
- Figure 4 is a cross-section of the microelectromechanical device of Figure 2, taken along line IV-IV of Figure 2;
- Figure 5 shows an enlarged detail of the microelectromechanical device of Figure 2;
- Figure 6 is a simplified block diagram of the test equipment of Figure 1;
- Figure 7 is a simplified block diagram of the microelectromechanical device of Figure 2 in use configuration;
- Figure 8 is a top-plan view of a microelectromechanical device in accordance with a different embodiment of the present invention;
- Figure 9 is a cross-section of the microelectromechanical device of Figure 8, taken along line IX-IX of Figure 8;
- Figures 10-15 are cross-sections of the wafer incorporating the microelectromechanical device of Figure 2 in successive processing steps of a method in accordance with an embodiment of the present invention.

### DESCRIPTION OF THE EMBODIMENTS

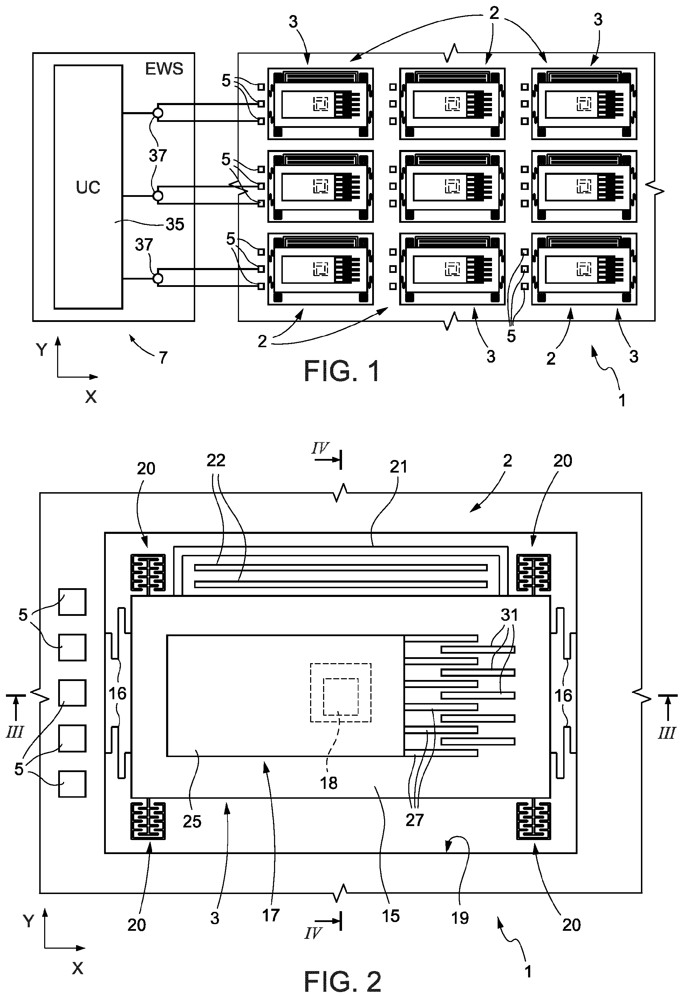

Figure 1 shows a top-plan view of a semiconductor wafer 1 and a plurality of microelectromechanical devices 2 in accordance with an embodiment of the invention integrated in the semiconductor wafer 1. In the case described and illustrated herein, the microelectromechanical devices 2 are two detection-axis gyroscopes, as explained in detail hereinbelow. However, this should not be understood in a limiting sense. The integrated microelectromechanical devices may include gyroscopes of any type (uniaxial, biaxial, triaxial), as well as other inertial sensors (accelerometers, inclinometers) and, in general, microelectromechanical devices having a microstructure with movable parts.

In the example of Figure 1, each microelectromechanical device 2 present in the wafer 1 comprises a microstructure 3 and respective pads 5, connected to the microstructure 3. A test machine 7, for example for EWS (Electrical Wafer Sorting) tests at the wafer level, is connected to the pads 5 to perform tests, at the wafer level, on the functionality of the microelectromechanical devices 2, in particular of the spurious vibration modes of the microstructures 3, as described in detail hereinbelow.

Figures 2-4 show in greater detail a portion of the wafer 1 where one of the microelectromechanical devices 2 is integrated. As may be seen from Figures 2-4, the wafer 1 comprises a substrate 8 of semiconductor material, for example monocrystalline silicon, a first structural layer 10, joined to the substrate 8 by a first dielectric layer 11, and a second structural layer 12, joined to the first structural layer 10 by a second dielectric layer 13. The first structural layer 10 and the second structural layer 12 may be semiconductor material layers grown by epitaxy (monocrystalline or polycrystalline epitaxial layers). The microstructure 3 is obtained from the first structural layer 10 and from the second structural layer 12 by separating, by anisotropic etchings, respective portions of the first structural layer 10 and of the second structural layer 12 from the rest of the first structural layer 10 and of the second structural layer 12.

The microstructure 3 comprises a movable mass 15, obtained from the first structural layer 10, and a test structure 17, obtained essentially from the first structural layer 10 and from the second structural layer 12 and provided with an anchor 18 for the mechanical and electrical connection to the substrate 8.

The first structural layer 10 and the second structural layer 12 delimit a cavity 19 wherein the movable mass 15 and the test structure 17 are accommodated. In particular, the first structural layer 10 forms a support frame for the movable mass 15. The second structural layer 12 in one embodiment supports the pads 5. The first dielectric layer 11 and the second dielectric layer 13 are not present inside the cavity 19.

The movable mass 15 is constrained to the first structural layer 10 by elastic connection elements 16. In practice, the substrate 8, the first structural layer 10, the first dielectric layer 11, the second structural layer 12 and the second dielectric layer 13 form a support body for the movable mass. In the embodiment described herein, the elastic connection elements 16 are configured to allow the movable mass 15 to oscillate in the cavity 19 with three translational degrees of freedom, parallel and perpendicular to a surface 8a of the substrate 8. The movable mass 15 is also provided with drive actuators 20, configured to oscillate the same movable mass 15 along a drive X-axis parallel to the surface 8a of the substrate 8. The movable mass 15 further comprises one or more movable yaw detection electrodes 21, facing corresponding fixed yaw detection electrodes 22, rigidly connected to the substrate 8. The movable yaw detection electrodes 21 and the fixed yaw detection electrodes 22 define capacitors having flat faces parallel to the X axis, with variable capacitance as a function of displacements of the movable mass 15 along an Y axis parallel to the surface 8a of the substrate 8 and perpendicular to the X axis. In the case of the microelectromechanical device 2, the movable mass 15 translates, along the Y axis, in response to yaw movements, i.e. rotations around an axis perpendicular to the surface 8a of the substrate 8. One of the sides of the movable mass 15, facing a respective fixed yaw detection electrode 22, may act as a movable yaw detection electrode 21.

Fixed pitch/roll detection electrodes 23 are located on the substrate 8 and face the movable mass 15, which acts as a movable pitch/roll detection electrode. The movable mass 15 and the fixed pitch/roll detection electrodes 23 define capacitors with variable capacitance as a function of displacements of the movable mass 15 along a Z axis perpendicular to the X axis and to the Y axis. In the case of the microelectromechanical device 2, the movable mass 15 translates, along the Z axis, in response to pitch and/or roll movements, i.e. rotations around an axis parallel to the surface 8a of the substrate 8.

The movable mass 15, with all the movable detection electrodes, and all the fixed detection electrodes are connected to respective pads 5 of the microelectromechanical device 1 through connection lines 26 formed on the substrate 8 and/or embedded therein.

The test structure 17 comprises a semiconductor material body which forms the anchor 18, a test plate 25 and a group of fixed test electrodes 27 and is fixed to the substrate 8. The test structure 17 is distinct from the drive actuators 20 and from the fixed detection electrodes 22, 23.

The anchor 18, obtained essentially from the first structural layer 10, includes a pillar fixed to a bias pad 28 placed on the substrate 8 and is electrically (galvanically) isolated both from the same substrate 8 and from the movable mass 15. The bias pad 28 is connected to one of the pads 5 of the microelectromechanical device 1 through one of the connection lines 26. In this manner, during the test step the anchor 18 and the entire test structure may be biased independently of the movable mass 15.

Furthermore, the anchor 18 extends in the direction of the Z axis through an opening 30 in the movable mass 15. The anchor 18 and the opening 30 have respective sides facing each other. In rest conditions, i.e. in the absence of forcing and external stresses, the anchor 18 is off-center with respect to the opening 30 in the movable mass 15. In one embodiment, in particular, a center C1 of the anchor 18 is offset with respect to a center C2 of the opening 30 in the direction of the Y axis, so that the anchor 18 is closer to one of the sides of the movable mass 15 delimiting the opening 30 in the direction of the Y axis than to the opposite side. The different distance causes a different capacitive coupling. Consequently, when a voltage is applied between the movable mass 15 and the anchor 18 of the test structure 17, the electrostatic forces acting on the movable mass 15 are not balanced and the movable mass 15 moves along the Y axis. The anchor 18 in practice defines a test actuator configured to apply test forces F_{Y} to the movable mass 15 in the direction of the Y axis. In the embodiment of Figures 2-4, the movable mass 15 is instead centered with respect to the opening 30 in the direction of the X axis. The forces in the direction of the X axis are therefore balanced and the capacitive coupling between the movable mass 15 and the anchor 18 does not affect the motion of the same movable mass 15.

The test plate 25 is obtained from the second structural layer 12, as are the fixed test electrodes 27, and is connected to the substrate 8 through the anchor 18. The movable mass 15 is arranged between the substrate 8 and the test plate 25 of the test structure 17. Therefore, the movable mass 15 has a first side 15a facing the substrate 8 and a second side 15b facing the test plate 25.

The movable mass 15 and the test plate 25 face each other and are capacitively coupled. Therefore, a voltage applied between the movable mass 15 and the test plate 25 of the test structure 17 causes electrostatic forces which move the movable mass 15 in the direction of the Z axis. The test plate 25 thus defines a test actuator configured to apply test forces F_{Z} to the movable mass 15 in the direction of the Z axis.

The fixed test electrodes 27 are defined by respective flat semiconductor plates which extend from one side of the test plate 25 parallel to an XZ plane defined by the X axis and the Z axis. The fixed test electrodes 27 are capacitively coupled to movable test electrodes 31 formed on one face of the movable mass 15 adjacent to the test plate 25. More precisely, the movable test electrodes 31 are defined by respective flat semiconductor plates parallel to the XZ plane, obtained from the second structural layer 12, and are arranged in interdigitated configuration with respect to the fixed test electrodes 27. A voltage applied between the fixed test electrodes 27 of the test structure 17 and the movable test electrodes 31 of the movable mass 15 causes electrostatic forces which move the movable mass 15 in the direction of the X axis. The fixed test electrodes 27 thus define a test actuator configured to apply test forces F_{X} to the movable mass 15 in the direction of the X axis.

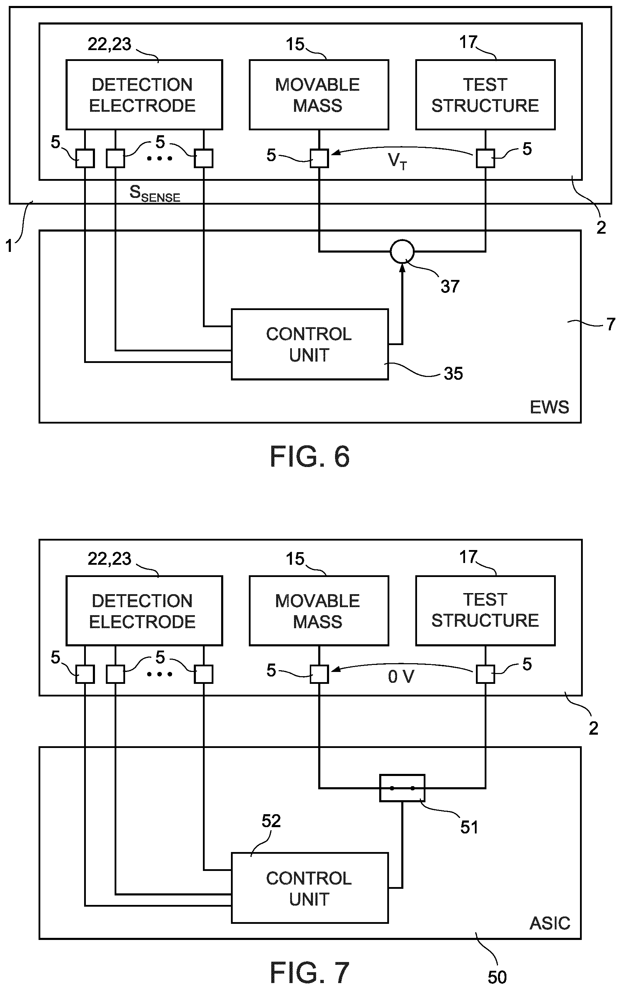

With reference to Figure 6, during an EWS test step, the test machine 7 is connected to the pads 5 of the microelectromechanical devices 2, or at least selectively to groups thereof, integrated in the wafer 1 (for simplicity Figure 7 illustrates only one microelectromechanical device 1 connected to the test machine 7; Figure 1 shows a greater number thereof). The test machine 7 comprises a control unit 35 and one or more test signal generators 37, controlled by the control unit 35.

The test signal generator 37 is coupled to respective pads 5 so as to apply a test voltage V_{T} between the movable mass 15 and the test structure 17 under the control of the control unit 35. The test voltage V_{T} may be for example a sinusoidal voltage with frequency and amplitude controlled by the control unit 35. For example, the frequency of the test voltage V_{T} may vary over time so as to stress different spurious vibration modes of the microstructure 3 of the microelectromechanical devices 2.

The control unit 35 also has inputs coupled to pads 5 connected to the (fixed) detection electrodes 22, 23 to receive sense signals S_{SENSE} in response to movements of the movable mass 15.

In use, on the other hand, each microelectromechanical device 2 obtained by dicing the wafer 1 is coupled to a respective control integrated circuit or ASIC (Application Specific Integrated Circuit) 50 which maintains the microstructure 15 and the test structure 17 at the same voltage, as shown in Figure 7. The connection between the microstructure 15 and the test structure 17 may be obtained for example through a switch 51 controlled by a control unit 52 of the ASIC 50 or by a permanent direct connection. In this manner, during normal operation of the microelectromechanical device 1, the test structure 17 has no impact on the response of the movable mass 15 because the voltage between the movable mass 15 and the test structure 17 is zero.

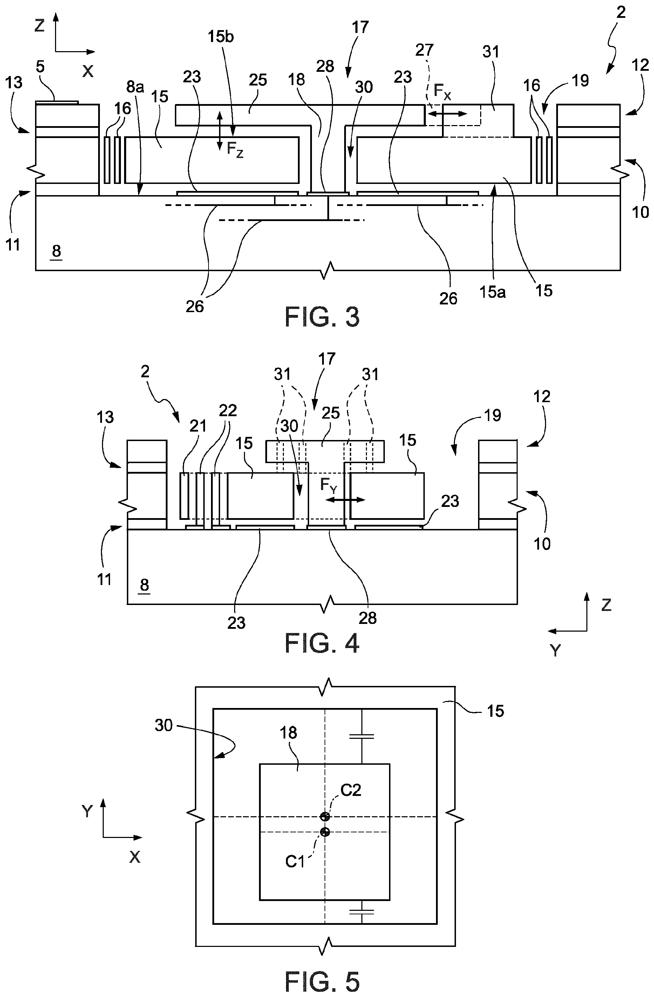

Owing to the capacitive coupling between the fixed test electrodes 27 and the movable test electrodes 31, between the anchor 18 and the movable mass 15 in the opening 30 and between the test plate 25 and the movable mass 15, the test voltage V_{T} causes test forces F_{X}, Fy, F_{Z} between the movable mass 15 and the test structure 17 respectively along the X axis, along the Y axis and along the Z axis, as illustrated in Figures 3 and 4. In turn, the test forces F_{X}, Fy, F_{Z} excite the spurious vibration modes of the microstructure 3 and the response is read through the sense signals S_{SENSE}, which contain spurious contributions superimposed on the signals induced by the test voltage V_{T}. The microelectromechanical devices 2 which have responses to the test voltage V_{T} above programmed thresholds are marked as defective.

In practice, therefore, the test structure 17 allows the effect of the spurious vibration modes of the microstructures 3 at the wafer level to be examined. The defective microelectromechanical devices 2 may be identified in a systematic manner and, once the wafer 1 has been diced, eliminated before the assembly operations. The test at the wafer level thus allows a considerable saving of method steps and materials used.

In terms of occupied area and sensitivity of the microelectromechanical devices, the test structure 17 has an almost negligible impact, limited to the dimensions of the opening 30 in the XY plane. In other words, with the same rail area, the reduction of sensitivity due to that the opening 30 reduces the inertia of the movable mass 5 is not significant; in a dual manner, any increase in the dimensions of the movable mass 15 to compensate for the opening 30 would be extremely small. The test structure 17 is in fact mostly superimposed on the movable mass 15 and increases the overall dimensions of the microelectromechanical device 1 mainly in the direction perpendicular to the surface 8a of the substrate 8 (along the Z axis). However, the increase in dimensions in this direction is usually not critical.

The invention may advantageously be exploited in microelectromechanical devices, in particular gyroscopes, with any configuration of movable masses.

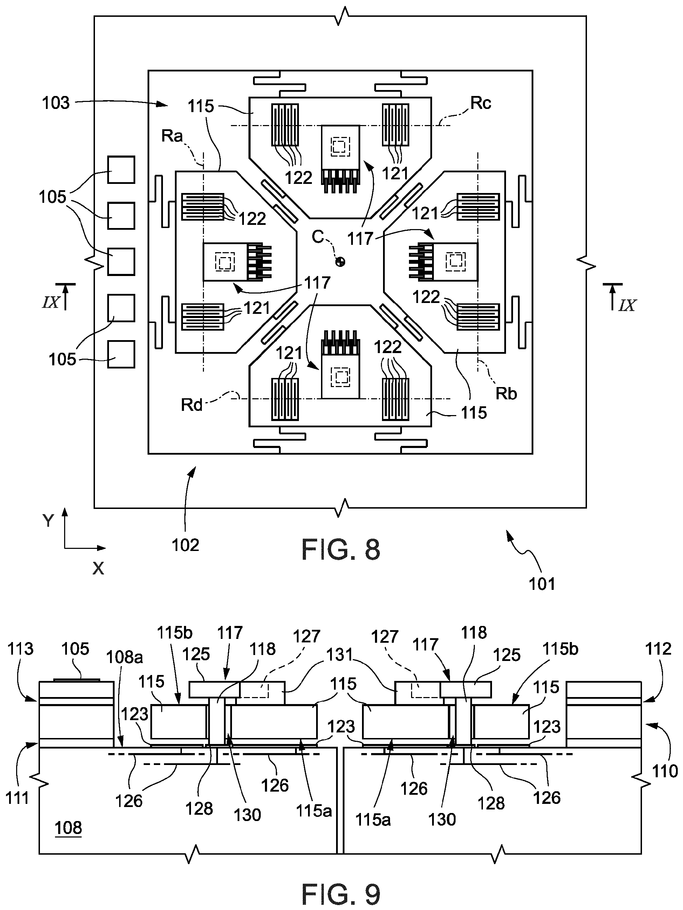

For example, according to the embodiment illustrated in Figures 8 and 9, a semiconductor wafer 101 comprises a plurality of microelectromechanical devices 102, in particular triaxial microelectromechanical gyroscopes, only one of which is shown for convenience.

Each microelectromechanical device 102 has a microstructure 103 which comprises a support body, four movable masses 115, arranged in specularly symmetrical pairs around a center C, and four test structures 117, each associated with a respective movable mass 115. The support body includes a substrate 108 of the wafer 101, a first structural layer 110, a first dielectric layer 111, a second structural layer 112 and a second dielectric layer 113. The first structural layer 110 and the second structural layer 112 are of semiconductor material, for example grown by epitaxy.

The movable masses 115 are constrained to the support body so as to oscillate in phase opposition in pairs, in a manner known per se. In particular, two movable masses 115 oscillate in phase opposition along an X axis parallel to the surface 108a of the substrate 108 and two movable masses 115 oscillate in phase opposition along an Y axis parallel to the surface 108a and perpendicular to the X axis. Furthermore, all the movable masses 115 oscillate in phase opposition in pairs around respective rotation axes Ra-Rd parallel to the surface 108a of the substrate 108.

The movable masses 115 are provided with respective systems of movable detection electrodes 121, capacitively coupled to respective fixed detection electrodes 122 anchored to the substrate 108. Further fixed detection electrodes 123 arranged on the substrate 108 are capacitively coupled to a face of a respective movable mass 115. The movable masses 115, with all the movable detection electrodes 121, and all the fixed detection electrodes 122, 123 are connected to respective pads 105 of the microelectromechanical device 101 through connection lines 126 formed on the substrate 108 and/or embedded therein.

Figure 9 shows two of the movable masses 115 and the relative test structures 117. It is understood that the other two movable masses 115 and test structures 117 are substantially identical to those shown in Figure 9.

Like the movable masses 115, the test structures 117 are also arranged in specularly symmetrical pairs with respect to the center C of the microelectromechanical device 101. Each test structure 117 comprises a semiconductor material body which forms an anchor 118, a test plate 125 and a group of fixed test electrodes 127 and is fixed to the substrate 108, substantially as already described. More precisely, each anchor 118 is fixed to a respective bias pad 128 placed on the substrate 108 and is electrically isolated both from the same substrate 108 and from the movable mass 115. The bias pads 128 are connected to respective pads 105 through the connection lines 126.

Each anchor 118 extends in the direction of the Z axis through an opening 130 in the respective movable mass 115. As already described, the anchors 18 are off-center with respect to the respective openings 130. For example, the anchors 118 of the test structures 117 associated with the movable masses 115 oscillating along the X axis are off-center in the direction of the Y axis, so as to define actuators which apply test forces F_{Y1} according to the Y axis. The anchors 118 of the test structures 117 associated with the movable masses 115 oscillating along the Y axis are off-center in the direction of the X axis, so as to define actuators which apply test forces F_{X1} according to the X axis.

The test plates 125 are connected to the substrate 108 through the respective anchors 118. The movable masses 115 are arranged between the substrate 108 on one side and the test plates 125 of the respective test structures 117 on the other side. Therefore, each movable mass 115 has a first side 115a facing the substrate 108 and a second side 115b facing the test plate 125.

The movable masses 115 and the respective test plates 125 face each other and are capacitively coupled. The test plates 125 thus define test actuators configured to apply electrostatic test forces F_{Z} to the respective movable masses 115 in the direction of the Z axis.

The fixed test electrodes 127 associated with the movable masses 115 oscillating along the X axis comprise respective flat semiconductor plates which extend on one side of the respective test plate 125 parallel to an XZ plane defined by the X axis and the Z axis. The fixed test electrodes 127 are capacitively coupled arranged in interdigitated configuration to movable test electrodes 131 formed on the respective movable masses 115. The fixed test electrodes 127 associated with the movable masses 115 oscillating along the X axis thus define test actuators configured to apply test forces F_{X2} to the respective movable masses 15 in the direction of the X axis.

The fixed test electrodes 127 associated with the movable masses 115 oscillating along the Y axis comprise respective flat semiconductor plates which extend on one side of the respective test plate 125 parallel to a YZ plane defined by the Y axis and the Z axis. The fixed test electrodes 127 are capacitively coupled arranged in interdigitated configuration to movable test electrodes 131 formed on the respective movable masses 115. The fixed test electrodes 127 associated with the movable masses 115 oscillating along the Y axis thus define test actuators configured to apply test forces F_{Y2} to the respective movable masses 115 in the direction of the Y axis.

During the test step, electrostatic forces directed according to the three axes X, Y, Z may be applied to the movable masses 115 through the respective test structures 117 substantially as already described, so as to excite the possible spurious vibration modes of the microstructure 103. Furthermore, the movable masses 115 may be forced into motion individually or simultaneously in various combinations (e.g., in opposite pairs or adjacent pairs) to have a wider range of stresses which may trigger spurious vibration modes.

The microelectromechanical device according to the invention may be obtained substantially using the method described in the European patent application EP 3 912 953 A1 published on 11/24/2021. The method will be summarily described with reference to the embodiment of Figures 1-5. However, it is understood that the same method may be applied for the embodiment of Figures 8, 9 and, more generally, for any embodiment of the invention. In practice, the movable mass 15, the test structure 17 and the fixed and movable detection electrodes are obtained from two structural layers grown epitaxially one on the other, as described in detail hereinbelow.

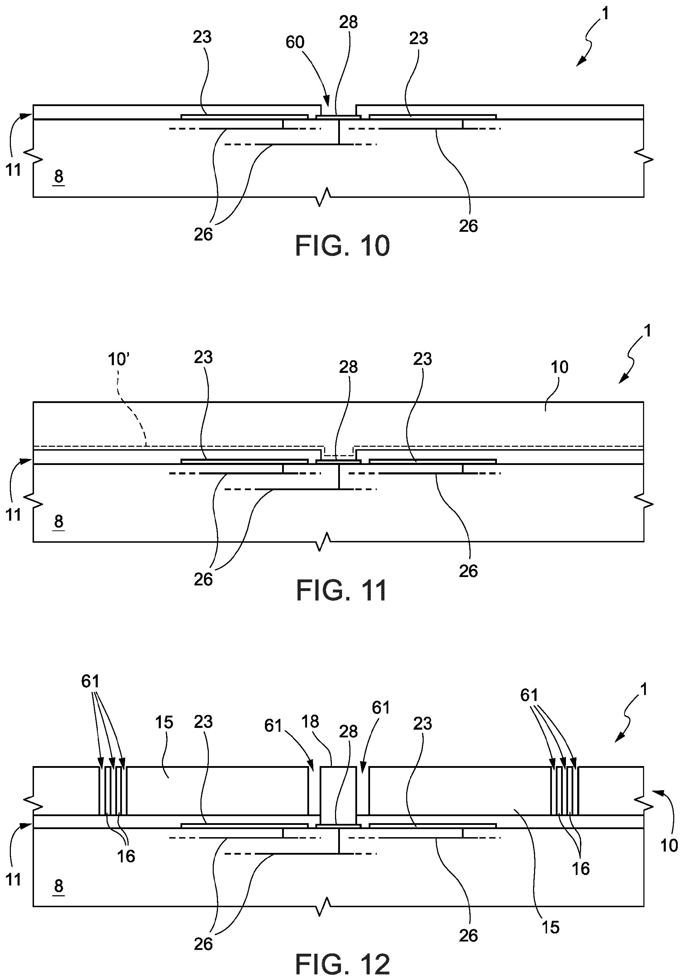

Initially (Figure 10), the connection lines 26 and, on the substrate 8, the fixed pitch/roll detection electrodes 23 and the bias pad 28 are formed. The first dielectric layer 11 is formed on the substrate 8 and is etched to form a window 60 on the bias pad 28, in a position corresponding to the anchor 18.

The first structural layer 10 is grown by epitaxy from a seed layer 10' deposited on the first dielectric layer 11 (Figure 11). The first structural layer 10 then extends over the first dielectric layer 11 and contacts the bias pad 28 through the window 60.

The first structural layer 10, Figure 12, is then etched to define the movable mass 15, the elastic connection elements 16, the anchor 18, the fixed yaw detection electrodes 22 (not visible in Figure 12) and possibly other regions provided based on design preferences. For this purpose, the wafer 1 is covered by a resist mask not shown (first trench mask) and subject to a dry etching, forming trenches 61, which completely traverse the first structural layer 10. In this step, trenches (not shown) are also formed through the portion of the first structural layer 10 intended to form the movable mass 15, which will have a lattice structure. The trenches will also serve in the subsequent steps for the removal of portions of the dielectric layer 11, to release the movable mass 15. The etching automatically stops on the first electric layer 11.

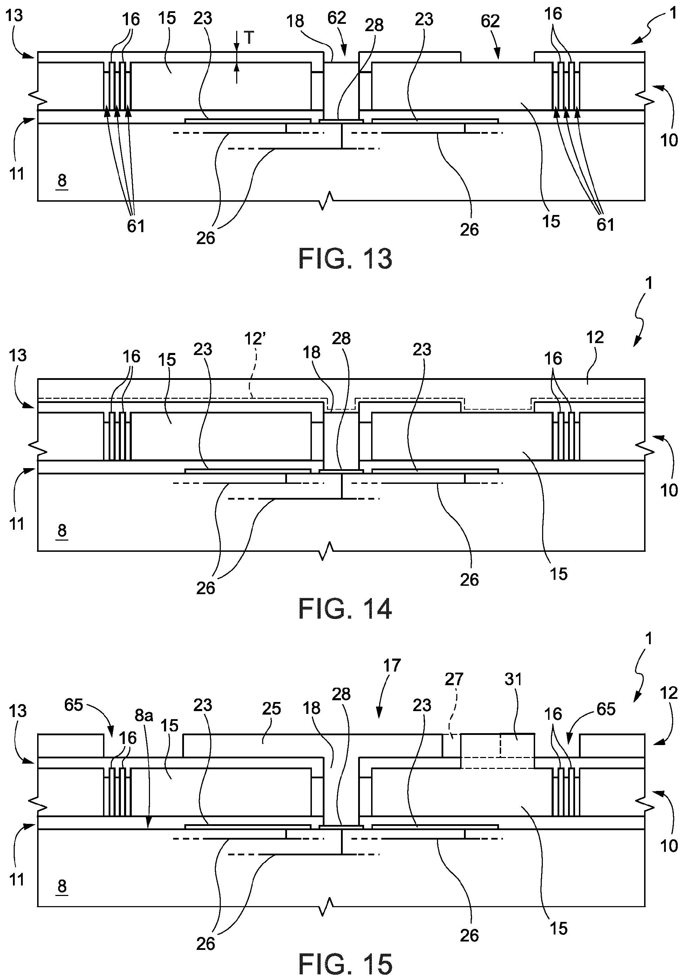

Subsequently, Figure 13, the second dielectric 13 is deposited, for a thickness T equal to a desired width of a gap between the movable mass 15 and the test plate 25 which will be formed subsequently. The second dielectric layer 13 partially fills the trenches 61, for example for one third of their depth although this filling, as well as the filling extent and depth are not important. The second dielectric layer 13 is then selectively etched and removed throughout its entire thickness, using a masking layer not shown, forming windows 62 in positions corresponding to the anchor 18 and to regions of the movable mass 15 where the movable test electrodes 31 will have to be formed subsequently.

As shown in Figure 14, the second structural layer 12 is then grown, also in this case by epitaxy, starting from a second deposited seed layer 12'. The thickness of the second structural layer 12 is linked to the desired micro-electro-mechanical structures. In general, the second structural layer 12 may be thinner than the first structural layer 10, although the reverse may occur and the invention is not limited to any particular ratio between the thicknesses of the structural layers 10, 12.

Then, Figure 15, the second structural layer 12 is etched. For this purpose, the wafer 1 is covered by a resist mask not shown (second trench mask) and subject to a dry etching. In this step, the portions of the second structural layer 12 not covered by the resist mask are removed throughout the entire thickness and the etching stops on the remaining portions of the second dielectric 13. In particular, in this step trenches 65 are opened which completely traverse the second structural layer 12 and the test plate 25, the fixed test electrodes 27 and the movable test electrodes 31 are defined.

Through the trenches 31, 65 and the trenches (not shown) through the movable mass 15, the second dielectric layer 13 and the first dielectric layer 11 are in succession partially removed over and under the movable mass 15, between the movable mass 15 and the test plate 25 and around the anchor 18. The movable mass 15 is thus released and the structure of Figures 2-4 is obtained.

Finally, it is clear that modifications and variations may be made to the microelectromechanical device, equipment and method described, without departing from the scope of the present invention, as defined in the attached claims.

For example, the fixed and movable test electrodes may form a parallel-plate rather than an interdigitated-plate type actuator. In this case, the fixed and movable electrodes extend in a direction perpendicular (rather than parallel) to the electrostatic force applied to the movable mass.

The anchor may be off-center with respect to the opening in the movable mass both with respect to the X axis and with respect to the Y axis and not only with respect to one of the two.

In some embodiments, the test structure might be limited to the off-center pillar extending through the opening into the movable mass and possibly comprises further fixed and movable test electrodes obtained from the first structural layer.

## Claims

1. A microelectromechanical device comprising:
a support body (8, 10-13; 108, 110-113);
at least one movable mass (15; 115) of semiconductor material, elastically constrained to the support body (8, 10-13; 108, 110-113) so as to be able to oscillate along one or more axes (X, Y, Z, Ra-Rd);
drive actuators (20) configured to oscillate the movable mass (15; 155) along a drive axis;
fixed detection electrodes (22, 23; 122, 123) rigidly connected to the support body (8, 10-13; 108, 110-113) and capacitively coupled to the at least one movable mass (15; 115); **characterized in that** the microelectromechanical device further comprises:
at least one test structure (17; 117) of semiconductor material, rigidly connected to the support body (8, 10-13; 108, 110-113) and distinct from the drive actuators (20) and from the fixed detection electrodes (22, 23; 122, 123);
wherein the at least one test structure (17; 117) is capacitively coupled to the at least one movable mass (15; 115) and is configured to apply electrostatic forces (F_{X}, F_{Y}, F_{Z}) to the at least one movable mass (15; 115) in response to a test voltage (V_{T}) between the at least one test structure (17; 117) and the at least one movable mass (15; 115);
wherein, in response to variations over time of the test voltage (V_{T}) between the at least one test structure (17; 117) and the at least one movable mass (15; 115), the test forces (F_{X}, F_{Y}, F_{Z}) between the movable mass (15) and the test structure (17) are configured to excite spurious vibration modes of a microstructure (3) comprising the movable mass (15) and the test structure (17).

2. The device according to claim 1, wherein the at least one test structure (17; 117) is electrically isolated from the movable mass (15; 115) and from the substrate (8; 108).

3. The device according to claim 1 or 2, wherein the support body (8, 10-13; 108, 110-113) includes a substrate (8; 108) of semiconductor material;
wherein the at least one test structure (17; 117) comprises a first portion (25, 27; 125, 127) and a second portion (18, 28; 118, 128);
wherein the at least one movable mass (15; 115) is arranged between the substrate (8; 108) and the first portion (25, 27; 125, 127) of the at least one test structure (17; 117);
and wherein the second portion (18, 28; 118, 128) of the at least one test structure (17; 117) is anchored to the substrate (8; 108) and extends through the at least one movable mass (15; 115).

4. The device according to claim 3, wherein the first portion (25, 27; 125, 127) of the at least one test structure (17; 117) comprises a test plate (25; 125) of semiconductor material and wherein the at least one movable mass (15; 115) has a first side (17a; 115a) facing the substrate (8; 108) and a second side (15b; 115b) facing the test plate (25; 125).

5. The device according to claim 3 or 4, wherein the first portion (25, 27; 125, 127) of the at least one test structure (17; 117) comprises fixed test electrodes (27; 127) and wherein the at least one movable mass (15; 115) comprises movable test electrodes (31; 131) capacitively coupled to the fixed test electrodes (27; 127).

6. The device according to claim 5 dependent on claim 4, wherein the fixed test electrodes (27; 127) extend from the test plate (25; 125) and the movable test electrodes (31; 131) are arranged on the second side (15b; 115b) of the at least one movable mass (15; 115) facing the test plate (25; 125).

7. The device according to claim 6, wherein the fixed test electrodes (27; 127) are defined by respective flat semiconductor plates extending from the test plate (25; 125) and the movable test electrodes (31; 131) are defined by respective flat semiconductor plates formed on a face of the movable mass (15; 115) adjacent to the test plate (25; 125) and wherein the fixed test electrodes (27; 127) and the movable test electrodes (31; 131) are interdigitated.

8. The device according to any of claims 3 to 7, wherein the at least one movable mass (15; 115) has an opening (30; 130) and wherein the second portion (18, 28; 118, 128) of the at least one test structure (17; 117) comprises an anchor (18, 28; 118, 128) connecting the first portion (25, 27; 125, 127) of the at least one test structure (17; 117) to the substrate (8; 108) and extending through the opening (30; 130) in the at least one movable mass (15; 115).

9. The device according to claim 8, wherein the anchor (18, 28; 118, 128) is off-center with respect to the opening (30; 130).

10. The device according to claim 9 dependent on claim 5, wherein the fixed test electrodes (27; 127) are configured to apply a first electrostatic test force (F_{X}) in a first direction (X) parallel to a surface (8a; 108a) of the substrate (8; 108) and wherein the anchor (18, 28; 118, 128) is off-center with respect to the opening (30; 130) in a second direction (Y) parallel to the surface (8a; 108a) of the substrate (8; 108) and perpendicular to the first direction (X).

11. The device according to any of the preceding claims, comprising a plurality of movable masses (115) of semiconductor material, elastically constrained to the support body (108, 110-113) so as to be able to oscillate with respective relative degrees of freedom; and
a plurality of test structures (117) of semiconductor material, rigidly connected to the support body (108, 110-113), distinct from the driving actuators and from the fixed detection electrodes (122, 123) and each capacitively coupled to a respective of the movable masses (115);
wherein the movable masses (115) and the respective test structures (117) are arranged in symmetrical pairs with respect to a center (C).

12. The device according to any of the preceding claims, comprising pads (5; 105) accessible from the outside, wherein the at least one movable mass (15; 115) and the at least one test structure (17; 117) are electrically coupled to respective pads (5; 105).

13. The device according to any of the preceding claims, comprising a control integrated circuit (50) connected to the pads (5) and configured to set a voltage between the at least one movable mass (15) and the at least one test structure (17) to zero in use.

14. A test equipment for testing microelectromechanical devices comprising a semiconductor wafer (1) integrating a plurality of microelectromechanical devices (2) according to claim 13 and a test machine (7) connected to the pads (5) of the microelectromechanical devices and comprising at least one test signal generator (37), configured to apply the test voltage (V_{T}) between the pads (5; 105) respectively coupled to the at least one movable mass (15) and to the at least one test structure (17).

15. A method for manufacturing a microelectromechanical device, comprising:
forming a support body (8, 10-13; 108, 110-113);
forming at least one movable mass (15; 115) of semiconductor material, elastically constrained to the support body (8, 10-13; 108, 110-113) so as to be able to oscillate along one or more axes (X, Y, Z, Ra-Rd) along one or more axes (X, Y, Z, Ra-Rd);
forming drive actuators (20) configured to oscillate the movable mass (15; 115) along a drive axis;
forming fixed detection electrodes (22, 23; 122, 123) rigidly connected to the support body (8, 10-13; 108, 110-113) and capacitively coupled to the at least one movable mass (15; 115); **characterized by**:
forming at least one test structure (17; 117) of semiconductor material, rigidly connected to the support body (8, 10-13; 108, 110-113) and distinct from the drive actuators (20) and from the fixed detection electrodes (22, 23; 122, 123);
wherein the at least one test structure (17; 117) is capacitively coupled to the at least one movable mass (15; 115) and is configured to apply electrostatic forces (F_{X}, F_{Y}, F_{Z}) to the at least one movable mass (15; 115) in response to a test voltage (V_{T}) between the at least one test structure (17; 117) and the at least one movable mass (15; 115);
wherein, in response to variations over time of the test voltage (V_{T}) between the at least one test structure (17; 117) and the at least one movable mass (15; 115), the test forces (F_{X}, F_{Y}, F_{Z}) between the movable mass (15) and the test structure (17) are configured to excite spurious vibration modes of a microstructure (3) comprising the movable mass (15) and the test structure (17).

16. The method according to claim 15, wherein:
forming the support body (8, 10-13; 108, 110-113) comprises forming a first dielectric layer (11; 111), growing a first structural layer (10; 110) on the first dielectric layer (11; 111) by epitaxy from a first deposited seed layer (10'), forming a second dielectric layer (13; 113) on the first structural layer (10; 110) and growing a second structural layer (12; 112) on the second dielectric layer (13; 113) by epitaxy from a second deposited seed layer (12');
forming the at least one movable mass (15; 115) comprises forming a first window (60) in the first dielectric layer (11; 111) before growing the first structural layer (10; 110) and selectively etching the first structural layer (10; 110) up to the first dielectric layer (11; 111); and
forming the at least one test structure (17; 117) comprises forming second windows (62) in the second dielectric layer (13; 113) before growing the second structural layer (12; 112) and selectively etching the second structural layer (12; 112) up to the second dielectric layer (13; 113).

## Patentansprüche

1. Mikroelektromechanische Vorrichtung, umfassend:
einen Stützkörper (8, 10-13; 108, 110-113);
mindestens eine bewegliche Masse (15; 115) aus Halbleitermaterial, die elastisch an den Stützkörper (8, 10-13; 108, 110-113) gebunden ist, um imstande zu sein, entlang einer oder mehrerer Achsen (X, Y, Z, Ra-Rd) zu schwingen;
Antriebsstellglieder (20), die konfiguriert sind, um die bewegliche Masse (15; 155) entlang einer Antriebsachse schwingen zu lassen;
fixierte Detektionselektroden (22, 23; 122, 123), die starr mit dem Stützkörper (8, 10-13; 108, 110-113) verbunden, und
kapazitiv mit der mindestens einen beweglichen Masse (15; 115) gekoppelt sind; **dadurch gekennzeichnet, dass** die mikroelektromechanische Vorrichtung weiter umfasst:
mindestens eine Prüfstruktur (17; 117) aus Halbleitermaterial, die starr mit dem Stützkörper (8, 10-13; 108, 110-113) verbunden, und sich von den Antriebsstellgliedern (20) und von den fixierten Detektionselektroden (22, 23; 122, 123) unterscheidet;
wobei die mindestens eine Prüfstruktur (17; 117) kapazitiv mit der mindestens einen beweglichen Masse (15; 115) gekoppelt ist und konfiguriert ist, um elektrostatische Kräfte (Fₓ, F_{Y}, F_{z}) auf die mindestens eine bewegliche Masse (15; 115) als Reaktion auf eine Prüfspannung (V_{T}) zwischen der mindestens einen Prüfstruktur (17; 117) und der mindestens einen beweglichen Masse (15; 115) anzuwenden;
wobei als Reaktion auf zeitliche Schwankungen der Prüfspannung (V_{T}) zwischen der mindestens einen Prüfstruktur (17; 117) und der mindestens einen beweglichen Masse (15; 115) die Prüfkräfte (Fₓ, Fy, F_{z}) zwischen der beweglichen Masse (15) und der Prüfstruktur (17) konfiguriert sind, um falsche Schwingungsmodi einer Mikrostruktur (3) anzuregen, welche die bewegliche Masse (15) und die Prüfstruktur (17) umfasst.

2. Vorrichtung nach Anspruch 1, wobei die mindestens eine Prüfstruktur (17; 117) von der beweglichen Masse (15; 115) und von dem Substrat (8; 108) elektrisch isoliert ist.

3. Vorrichtung nach Anspruch 1 oder 2, wobei der Stützkörper (8, 10-13; 108, 110-113) ein Substrat (8; 108) aus Halbleitermaterial beinhaltet;
wobei die mindestens eine Prüfstruktur (17; 117) einen ersten Abschnitt (25, 27; 125, 127) und einen zweiten Abschnitt (18, 28; 118, 128) umfasst;
wobei die mindestens eine bewegliche Masse (15; 115) zwischen dem Substrat (8; 108) und dem ersten Abschnitt (25, 27; 125, 127) der mindestens einen Prüfstruktur (17; 117) angeordnet ist;
und wobei der zweite Abschnitt (18, 28; 118, 128) der mindestens einen Prüfstruktur (17; 117) an dem Substrat (8; 108) verankert ist und sich durch die mindestens eine bewegliche Masse (15; 115) hindurch erstreckt.

4. Vorrichtung nach Anspruch 3, wobei der erste Abschnitt (25, 27; 125, 127) der mindestens einen Prüfstruktur (17; 117) eine Prüfplatte (25; 125) aus Halbleitermaterial umfasst und wobei die mindestens eine bewegliche Masse (15; 115) eine dem Substrat (8; 108) zugewandte erste Seite (17a; 115a) und eine der Prüfplatte (25; 125) zugewandte zweite Seite (15b; 115b) aufweist.

5. Vorrichtung nach Anspruch 3 oder 4, wobei der erste Abschnitt (25, 27; 125, 127) der mindestens einen Prüfstruktur (17; 117) fixierte Prüfelektroden (27; 127) umfasst und wobei die mindestens eine bewegliche Masse (15; 115) bewegliche Prüfelektroden (31; 131) umfasst, die kapazitiv mit den fixierten Prüfelektroden (27; 127) gekoppelt sind.

6. Vorrichtung nach Anspruch 5, von Anspruch 4 abhängig, wobei sich die fixierten Prüfelektroden (27; 127) von der Prüfplatte (25; 125) erstrecken und die beweglichen Prüfelektroden (31; 131) auf der der Prüfplatte (25; 125) zugewandten zweiten Seite (15b; 115b) der mindestens einen beweglichen Masse (15; 115) angeordnet sind.

7. Vorrichtung nach Anspruch 6, wobei die fixierten Prüfelektroden (27; 127) durch jeweilige flache Halbleiterplatten definiert sind, die sich von der Prüfplatte (25; 125) erstrecken, und die beweglichen Prüfelektroden (31; 131) durch jeweilige flache Halbleiterplatten definiert sind, die auf einer Fläche der beweglichen Masse (15; 115) neben der Prüfplatte (25; 125) angeordnet sind, und wobei die fixierten Prüfelektroden (27; 127) und die beweglichen Prüfelektroden (31; 131) ineinandergreifen.

8. Vorrichtung nach einem der Ansprüche 3 bis 7, wobei die mindestens eine bewegliche Masse (15; 115) eine Öffnung (30; 130) aufweist und wobei der zweite Abschnitt (18, 28; 118, 128) der mindestens einen Prüfstruktur (17; 117) einen Anker (18, 28; 118, 128) umfasst, der den ersten Abschnitt (25, 27; 125, 127) der mindestens einen Prüfstruktur (17; 117) mit dem Substrat (8; 108) verbindet und sich durch die Öffnung (30; 130) in der mindestens einen beweglichen Masse (15; 115) hindurch erstreckt.

9. Vorrichtung nach Anspruch 8, wobei der Anker (18, 28; 118, 128) in Bezug zur Öffnung (30; 130) außerhalb der Mitte liegt.

10. Vorrichtung nach Anspruch 9, von Anspruch 5 abhängig, wobei die fixierten Prüfelektroden (27; 127) konfiguriert sind, um eine erste elektrostatische Prüfkraft (Fₓ) in einer ersten Richtung (X) parallel zu einer Oberfläche (8a; 108a) des Substrats (8; 108) anzuwenden, und wobei der Anker (18, 28; 118, 128) in einer zweiten Richtung (Y) parallel zur Oberfläche (8a; 108a) des Substrats (8; 108) und senkrecht zu der ersten Richtung (X) in Bezug zur Öffnung (30; 130) außerhalb der Mitte liegt.

11. Vorrichtung nach einem der vorstehenden Ansprüche, die eine Vielzahl von beweglichen Massen (115) aus Halbleitermaterial umfasst, die elastisch an den Stützkörper (108, 110-113) gebunden sind, um imstande zu sein, mit jeweiligen relativen Freiheitsgraden zu schwingen; und
eine Vielzahl von Prüfstrukturen (117) aus Halbleitermaterial, die starr mit dem Stützkörper (108, 110- 113) verbunden sind, die sich von den Antriebsstellgliedern und den fixierten Detektionselektroden (122, 123) unterscheiden und jeweils kapazitiv mit einer der beweglichen Massen (115) gekoppelt sind;
wobei die beweglichen Massen (115) und die jeweiligen Prüfstrukturen (117) in Bezug zu einer Mitte (C) in symmetrischen Paaren angeordnet sind.

12. Vorrichtung nach einem der vorstehenden Ansprüche, die von außen zugängliche Beläge (5; 105) umfasst, wobei die mindestens eine bewegliche Masse (15; 115) und die mindestens eine Prüfstruktur (17; 117) elektrisch mit jeweiligen Belägen (5; 105) gekoppelt sind.

13. Vorrichtung nach einem der vorstehenden Ansprüche, die eine integrierte Steuerschaltung (50) umfasst, die mit den Belägen (5) verbunden ist und konfiguriert ist, um die Spannung zwischen der mindestens einen beweglichen Masse (15) und der mindestens einen Prüfstruktur (17) im Gebrauch auf null zu setzen.

14. Prüfausrüstung zum Prüfen mikroelektromechanischer Vorrichtungen, die einen Halbleiterwafer (1), der eine Vielzahl von mikroelektromechanischen Vorrichtungen (2) nach Anspruch 13 integriert, und eine Prüfmaschine (7), die mit den Belägen (5) der mikroelektromechanischen Vorrichtungen verbunden ist, umfasst und mindestens einen Prüfsignalgenerator (37) umfasst, der konfiguriert ist, um eine Prüfspannung (V_{T}) zwischen den Belägen (5; 105) anzulegen, die jeweils mit der mindestens einen beweglichen Masse (15) und der mindestens einen Prüfstruktur (17) gekoppelt sind.

15. Verfahren zur Herstellung einer mikroelektromechanischen Vorrichtung, umfassend:
Bilden eines Stützkörpers (8, 10-13; 108, 110-113);
Bilden mindestens einer beweglichen Masse (15; 115) aus Halbleitermaterial, die elastisch an den Stützkörper (8, 10-13; 108, 110-113) gebunden ist, um imstande zu sein, entlang einer oder mehrerer Achsen (X, Y, Z, Ra-Rd) entlang einer oder mehrerer Achsen (X, Y, Z, Ra-Rd) zu schwingen; Bilden von Antriebsstellgliedern (20), die konfiguriert sind, um die bewegliche Masse (15; 115) entlang einer Antriebsachse schwingen zu lassen;
Bilden fixierter Detektionselektroden (22, 23; 122, 123), die starr mit dem Stützkörper (8, 10-13; 108, 110-113) verbunden sind und kapazitiv mit der mindestens einen beweglichen Masse (15; 115) gekoppelt sind; **gekennzeichnet durch**:
Bilden mindestens einer Prüfstruktur (17; 117) aus Halbleitermaterial, die starr mit dem Stützkörper (8, 10-13; 108, 110-113) verbunden ist, und sich von den Antriebsstellgliedern (20) und von den fixierten Detektionselektroden (22, 23; 122, 123) unterscheidet;
wobei die mindestens eine Prüfstruktur (17; 117) kapazitiv mit der mindestens einen beweglichen Masse (15; 115) gekoppelt ist und konfiguriert ist, um elektrostatische Kräfte (Fₓ, Fy, F_{z}) auf die mindestens eine bewegliche Masse (15; 115) als Reaktion auf eine Prüfspannung (V_{T}) zwischen der mindestens einen Prüfstruktur (17; 117) und der mindestens einen beweglichen Masse (15; 115) anzuwenden;
wobei als Reaktion auf zeitliche Schwankungen der Prüfspannung (V_{T}) zwischen der mindestens einen Prüfstruktur (17; 117) und der mindestens einen beweglichen Masse (15; 115) die Prüfkräfte (Fₓ, Fy, F_{z}) zwischen der beweglichen Masse (15) und der Prüfstruktur (17) konfiguriert sind, um falsche Schwingungsmodi einer Mikrostruktur (3) anzuregen, welche die bewegliche Masse (15) und die Prüfstruktur (17) umfasst.

16. Verfahren nach Anspruch 15, wobei:
Bilden des Stützkörpers (8, 10-13; 108, 110-113) Bilden einer ersten dielektrischen Schicht (11; 111), Züchten einer ersten Strukturschicht (10; 110) auf der ersten dielektrischen Schicht (11; 111) durch Epitaxie aus einer ersten abgeschiedenen Keimschicht (10'), Bilden einer zweiten dielektrischen Schicht (13; 113) auf der ersten Strukturschicht (10; 110) und Züchten einer zweiten Strukturschicht (12; 112) auf der zweiten dielektrischen Schicht (13; 113) durch Epitaxie aus einer zweiten abgeschiedenen Keimschicht (12') umfasst;
Bilden der mindestens einen beweglichen Masse (15; 115) Bilden eines ersten Fensters (60) in der ersten dielektrischen Schicht (11; 111) vor dem Züchten der ersten Strukturschicht (10; 110) und selektives Ätzen der ersten Strukturschicht (10; 110) bis zur ersten dielektrischen Schicht (11; 111) umfasst; und
Bilden der mindestens einen Prüfstruktur (17; 117) Bilden von zweiten Fenstern (62) in der zweiten dielektrischen Schicht (13; 113) vor dem Züchten der zweiten Strukturschicht (12; 112) und selektives Ätzen der zweiten Strukturschicht (12; 112) bis zu der zweiten dielektrischen Schicht (13; 113) umfasst.

## Revendications

1. Dispositif microélectromécanique comprenant :
un corps de support (8, 10-13 ; 108, 110-113) ;
au moins une masse mobile (15 ; 115) de matériau semi-conducteur, contrainte élastiquement au corps de support (8, 10-13 ; 108, 110-113) de manière à pouvoir osciller le long d'un ou plusieurs axes (X, Y, Z, Ra-Rd) ;
des actionneurs d'entraînement (20) conçus pour osciller la masse mobile (15 ; 155) le long d'un axe d'entraînement ;
des électrodes de détection fixes (22, 23 ; 122, 123) reliées rigidement au corps de support (8, 10-13 ; 108, 110-113) et
couplées de manière capacitive à au moins une masse mobile (15 ; 115) ; **caractérisé en ce que** le dispositif microélectromécanique comprend en outre :
au moins une structure de test (17 ; 117) en matériau semi-conducteur, reliée rigidement au corps de support (8, 10-13 ; 108, 110-113) et distincte des actionneurs d'entraînement (20) et des électrodes de détection fixes (22, 23 ; 122, 123) ;
dans lequel au moins une structure de test (17 ; 117) est couplée de manière capacitive à l'au moins une masse mobile (15 ; 115) et est configurée pour appliquer des forces électrostatiques (Fₓ, F_{y}, F_{z}) à l'au moins une masse mobile (15 ; 115) en réponse à une tension de test (V_{T}) entre l'au moins une structure de test (17 ; 117) et l'au moins une masse mobile (15 ; 115) ;
dans lequel, en réponse à des variations temporelles de la tension de test (V_{T}) entre l'au moins une structure de test (17 ; 117) et l'au moins une masse mobile (15 ; 115), les forces de test (Fₓ, F_{y}, F_{z}) entre la masse mobile (15) et la structure de test (17) sont configurées pour exciter des modes de vibration indésirables d'une microstructure (3) comprenant la masse mobile (15) et la structure de test (17).

2. Dispositif selon la revendication 1, dans lequel l'au moins une structure de test (17 ; 117) est électriquement isolée de la masse mobile (15 ; 115) et du substrat (8 ; 108).

3. Dispositif selon la revendication 1 ou 2, dans lequel le corps de support (8, 10-13 ; 108, 110-113) comprend un substrat (8 ; 108) en matériau semi-conducteur ;
dans lequel l'au moins une structure de test (17 ; 117) comprend une première partie (25, 27 ; 125, 127) et une seconde partie (18, 28 ; 118, 128) ;
dans lequel l'au moins une masse mobile (15 ; 115) est agencée entre le substrat (8 ; 108) et la première partie (25, 27 ; 125, 127) de l'au moins une structure de test (17 ; 117) ;
et dans lequel la seconde partie (18, 28 ; 118, 128) de l'au moins une structure de test (17 ; 117) est ancrée au substrat (8 ; 108) et s'étend à travers l'au moins une masse mobile (15 ; 115).

4. Dispositif selon la revendication 3, dans lequel la première partie (25, 27 ; 125, 127) de l'au moins une structure de test (17 ; 117) comprend une plaque de test (25 ; 125) en matériau semi-conducteur et dans lequel l'au moins une masse mobile (15 ; 115) présente un premier côté (17a ; 115a) orienté vers le substrat (8 ; 108) et un second côté (15b ; 115b) orienté vers la plaque de test (25 ; 125).

5. Dispositif selon la revendication 3 ou 4, dans lequel la première partie (25, 27 ; 125, 127) de l'au moins une structure de test (17 ; 117) comprend des électrodes de test fixes (27 ; 127) et dans lequel l'au moins une masse mobile (15 ; 115) comprend des électrodes de test mobiles (31 ; 131) couplées de manière capacitive aux électrodes de test fixes (27 ; 127).

6. Dispositif selon la revendication 5 dépendant de la revendication 4, dans lequel les électrodes de test fixes (27 ; 127) s'étendent à partir de la plaque de test (25 ; 125) et les électrodes de test mobiles (31 ; 131) sont agencées sur le second côté (15b ; 115b) de l'au moins une masse mobile (15 ; 115) faisant face à la plaque de test (25 ; 125).

7. Dispositif selon la revendication 6, dans lequel les électrodes de test fixes (27 ; 127) sont définies par des plaques semi-conductrices plates respectives s'étendant à partir de la plaque de test (25 ; 125) et les électrodes de test mobiles (31 ; 131) sont définies par des plaques semi-conductrices plates respectives formées sur une face de la masse mobile (15 ; 115) adjacente à la plaque de test (25 ; 125), et dans lequel les électrodes de test fixes (27 ; 127) et les électrodes de test mobiles (31 ; 131) sont interdigitées.

8. Dispositif selon l'une quelconque des revendications 3 à 7, dans lequel l'au moins une masse mobile (15 ; 115) présente une ouverture (30 ; 130) et dans lequel la seconde partie (18, 28 ; 118, 128) de l'au moins une structure de test (17 ; 117) comprend une ancre (18, 28 ; 118, 128) reliant la première partie (25, 27 ; 125, 127) de l'au moins une structure de test (17 ; 117) au substrat (8 ; 108) et s'étendant à travers l'ouverture (30 ; 130) dans l'au moins une masse mobile (15 ; 115).

9. Dispositif selon la revendication 8, dans lequel l'ancrage (18, 28 ; 118, 128) est décalé par rapport à l'ouverture (30 ; 130).

10. Dispositif selon la revendication 9 dépendant de la revendication 5, dans lequel les électrodes de test fixes (27 ; 127) sont configurées pour appliquer une première force de test électrostatique (Fₓ) dans une première direction (X) parallèle à une surface (8a ; 108a) du substrat (8 ; 108) et dans lequel l'ancrage (18, 28 ; 118, 128) est décentré par rapport à l'ouverture (30 ; 130) dans une seconde direction (Y) parallèle à la surface (8a ; 108a) du substrat (8 ; 108) et perpendiculaire à la première direction (X).

11. Dispositif selon l'une quelconque des revendications précédentes, comprenant une pluralité de masses mobiles (115) en matériau semi-conducteur, contraintes élastiquement au corps de support (108, 110-113) de manière à pouvoir osciller avec des degrés de liberté relatifs respectifs ; et
une pluralité de structures de test (117) en matériau semi-conducteur, reliées rigidement au corps de support (108, 110-113), distinctes des actionneurs de commande et des électrodes de détection fixes (122, 123) et chacune étant couplée de manière capacitive à l'une des masses mobiles (115) respectives ;
dans lequel les masses mobiles (115) et les structures de test (117) respectives sont agencées en paires symétriques par rapport à un centre (C).

12. Dispositif selon l'une quelconque des revendications précédentes, comprenant des pads (5 ; 105) accessibles de l'extérieur, dans lequel l'au moins une masse mobile (15 ; 115) et l'au moins une structure de test (17 ; 117) sont couplées électriquement à des pads (5 ; 105) respectifs.

13. Dispositif selon l'une quelconque des revendications précédentes, comprenant un circuit intégré de commande (50) connecté aux pads (5) et configuré pour mettre à zéro en utilisation une tension entre l'au moins une masse mobile (15) et l'au moins une structure de test (17).

14. Équipement de test pour l'évaluation de dispositifs microélectromécaniques comprenant une plaquette semiconductrice (1) intégrant une pluralité de dispositifs microélectromécaniques (2) selon la revendication 13, ainsi qu'une machine de test (7) connectée aux pads (5) des dispositifs microélectromécaniques et comprenant au moins l'un générateur de signal de test (37), configuré pour appliquer une tension de test (V_{T}) entre les pads (5 ; 105) respectivement couplés à l'au moins une masse mobile (15) et à l'au moins une structure de test (17).

15. Procédé de fabrication d'un dispositif microélectromécanique, comprenant :
la formation d'un corps de support (8, 10-13 ; 108, 110-113) ;
la formation d'au moins une masse mobile (15 ; 115) de matériau semi-conducteur, contrainte élastiquement au corps de support (8, 10-13 ; 108, 110-113) de manière à pouvoir osciller le long d'un ou plusieurs axes (X, Y, Z, Ra-Rd) le long d'un ou plusieurs axes (X, Y, Z, Ra-Rd) ;
la formation d'actionneurs d'entraînement (20) conçus pour osciller la masse mobile (15 ; 115) le long d'un axe d'entraînement ;
la formation d'électrodes de détection fixes (22, 23 ; 122, 123) reliées rigidement au corps de support (8, 10-13 ; 108, 110-113) et couplées de manière capacitive à l'au moins une masse mobile (15 ; 115) ; **caractérisé par** :
la formation d'au moins une structure de test (17 ; 117) en matériau semi-conducteur, reliée rigidement au corps de support (8, 10-13 ; 108, 110-113) et distincte des actionneurs d'entraînement (20) et des électrodes de détection fixes (22, 23 ; 122, 123) ;
dans lequel au moins une structure de test (17 ; 117) est couplée de manière capacitive à l'au moins une masse mobile (15 ; 115) et est configurée pour appliquer des forces électrostatiques (Fₓ, F_{y}, F_{z}) à l'au moins une masse mobile (15 ; 115) en réponse à une tension de test (V_{T}) entre l'au moins une structure de test (17 ; 117) et l'au moins une masse mobile (15 ; 115) ;
dans lequel, en réponse à des variations temporelles de la tension de test (V_{T}) entre l'au moins une structure de test (17 ; 117) et l'au moins une masse mobile (15 ; 115), les forces de test (Fₓ, F_{y}, F_{z}) entre la masse mobile (15) et la structure de test (17) sont configurées pour exciter des modes de vibration indésirables d'une microstructure (3) comprenant la masse mobile (15) et la structure de test (17).

16. Procédé selon la revendication 15, dans lequel :
la formation du corps de support (8, 10-13 ; 108, 110-113) comprend la formation d'une première couche diélectrique (11 ; 111), la croissance d'une première couche structurelle (10 ; 110) sur la première couche diélectrique (11 ; 111) par épitaxie à partir d'une première couche de semence déposée (10'), la formation d'une seconde couche diélectrique (13 ; 113) sur la première couche structurelle (10 ; 110) et la croissance d'une seconde couche structurelle (12 ; 112) sur la seconde couche diélectrique (13 ; 113) par épitaxie à partir d'une seconde couche de semence déposée (12') ;
la formation de l'au moins une masse mobile (15 ; 115) comprend la formation d'une première fenêtre (60) dans la première couche diélectrique (11 ; 111) avant la croissance de la première couche structurelle (10 ; 110) et la gravure sélective de la première couche structurelle (10 ; 110) jusqu'à la première couche diélectrique (11 ; 111) ; et
la formation de l'au moins une structure de test (17 ; 117) comprend la formation des fenêtres secondaires (62) dans la seconde couche diélectrique (13 ; 113) avant de faire croître la seconde couche structurelle (12 ; 112) et de procéder à la gravure sélective de la seconde couche structurelle (12 ; 112) jusqu'à la seconde couche diélectrique (13 ; 113).
